(19) **Europäisches Patentamt / European Patent Office / Office européen des brevets**

(11) **EP 4 186 110 B1**

(12) **FASCICULE DE BREVET EUROPEEN**

(45) Date de publication et mention de la délivrance du brevet:
**22.05.2024 Bulletin 2024/21**

(21) Numéro de dépôt: **21748636.4**

(22) Date de dépôt: **23.07.2021**

(51) Classification Internationale des Brevets (IPC):
**H01L 31/18** *(2006.01)* **H01L 31/0747** *(2012.01)*

(52) Classification Coopérative des Brevets (CPC):
**H01L 31/1868; H01L 31/0747;** Y02E 10/50;
Y02P 70/50

(86) Numéro de dépôt international:
**PCT/EP2021/070648**

(87) Numéro de publication internationale:
**WO 2022/018254 (27.01.2022 Gazette 2022/04)**

(54) **PROCÉDÉ DE TRAITEMENT PAR BALAYAGE D'UNE CELLULE PHOTOVOLTAÏQUE À HÉTÉROJONCTION**

VERFAHREN ZUR BEHANDLUNG EINER FOTOVOLTAISCHEN ZELLE MIT HETEROÜBERGANG DURCH SCANNEN

PROCESS FOR TREATING A HETEROJUNCTION PHOTOVOLTAIC CELL BY SCANNING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats de validation désignés:
**MA**

(30) Priorité: **24.07.2020 FR 2007824**
**24.07.2020 FR 2007826**

(43) Date de publication de la demande:
**31.05.2023 Bulletin 2023/22**

(73) Titulaire: **Commissariat à l'Energie Atomique et aux Energies Alternatives**
**75015 Paris (FR)**

(72) Inventeurs:
• **CHATELAIN, Marc**
**38054 GRENOBLE CEDEX 09 (FR)**
• **ALBARIC, Mickaël**
**38054 GRENOBLE CEDEX 09 (FR)**
• **KINFACK LEOGA, Arnaud**
**38054 GRENOBLE CEDEX 09 (FR)**
• **PELLETIER, David**
**38054 GRENOBLE CEDEX 09 (FR)**
• **VEIRMAN, Jordi**
**38054 GRENOBLE CEDEX 09 (FR)**

(74) Mandataire: **Cabinet Camus Lebkiri**
**25 rue de Maubeuge**
**75009 Paris (FR)**

(56) Documents cités:
**WO-A1-2013/001440 WO-A1-2021/018757**
**CN-A- 107 546 296**

**Description**

**DOMAINE TECHNIQUE**

La présente invention concerne un procédé de traitement d'un empilement obtenu lors de la fabrication d'une cellule photovoltaïque à hétérojonction, afin d'améliorer et stabiliser le rendement de la cellule photovoltaïque.

**ÉTAT DE LA TECHNIQUE**

Une cellule photovoltaïque à hétérojonction est un dispositif capable d'absorber le rayonnement solaire et de le convertir en énergie électrique. Un tel dispositif comprend une jonction p-n formée par la superposition de deux matériaux semi-conducteurs ayant des largeurs de bande interdite différentes, tels que le silicium cristallin et le silicium amorphe.

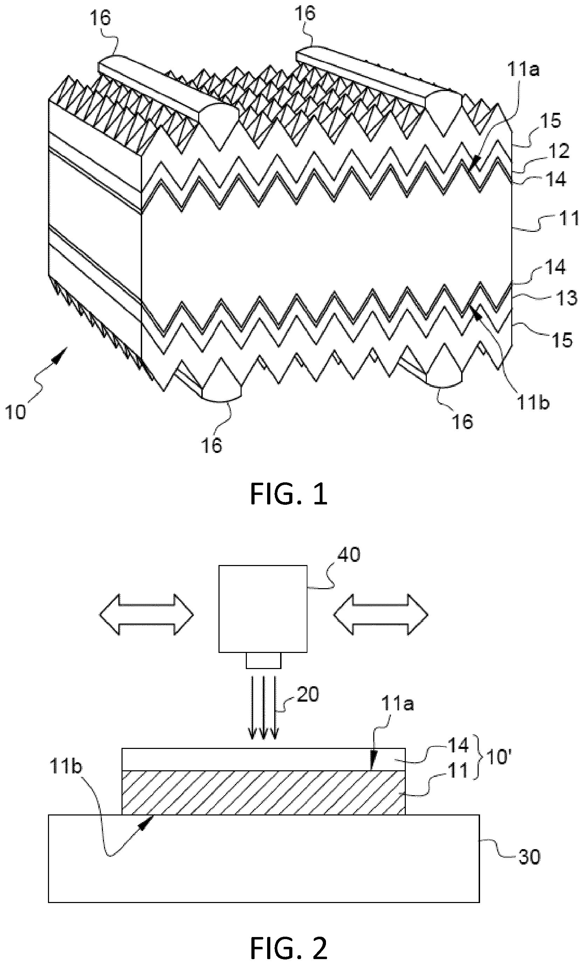

La figure 1 représente un exemple de cellule photovoltaïque 10 à hétérojonction de silicium (SHJ). La cellule photovoltaïque 10 comprend un substrat 11 en silicium cristallin dopé et deux couches de silicium amorphe 12-13 disposées de part et d'autre du substrat 11. L'une des couches de silicium amorphe 12-13 est dopée du même type de conductivité que le substrat 11, par exemple de type n, et l'autre couche est dopée du type de conductivité opposé, c'est-à-dire de type p.

L'hétérojonction est formée par le substrat 11 en silicium cristallin dopé n et la couche de silicium amorphe dopé p, cette couche formant l'émetteur de la cellule photovoltaïque. L'émetteur peut être situé en face avant ou en face arrière de la cellule photovoltaïque.

La cellule photovoltaïque SHJ est particulièrement sensible aux défauts situés à l'interface entre le substrat 11 en silicium cristallin et les couches de silicium amorphe 12-13. Ces défauts peuvent être des liaisons pendantes, également appelées « dangling bonds » en anglais, ou des impuretés telles que des ions métalliques. Ils introduisent des niveaux d'énergie dans la bande interdite du silicium et augmentent le nombre de recombinaisons électron-trou aux interfaces, ce qui détériore les paramètres de sortie de la cellule photovoltaïque, tels que la tension en circuit ouvert Voc.

Pour obtenir une cellule photovoltaïque performante, il est donc nécessaire de minimiser le nombre de recombinaisons en surface du substrat 11, ce qui est généralement accompli en déposant une couche de passivation 14 en silicium amorphe hydrogéné intrinsèque sur chacune des faces du substrat 11, avant la couche de silicium amorphe 12, 13. Les atomes d'hydrogène contenus dans les couches de passivation 14 diffusent jusqu'à la surface du substrat 11 et neutralisent les défauts.

Chacune des couches de silicium amorphe 12-13 est par ailleurs recouverte d'une couche d'oxyde transparent conducteur (ou TCO, pour « Transparent Conductive Oxyde » en anglais) 15.

Les cellules photovoltaïques SHJ sont connues pour voir leur rendement de conversion énergétique s'améliorer d'environ 0,3 % absolu sous l'action conjuguée de l'éclairement et de la température. Ce phénomène de bonification des cellules résulte de l'amélioration d'au moins une des couches de passivation 14 en silicium amorphe hydrogéné, ainsi que de l'amélioration des interfaces entre les couches de silicium amorphe 12-13 et les couches de TCO 15.

Le document WO2013/001440 décrit un exemple de procédé de traitement de cellule photovoltaïque SHJ comprenant un substrat en silicium cristallin dopé n. Dans ce procédé de traitement, la cellule photovoltaïque est soumise à un flux lumineux d'irradiance supérieure ou égale à 500 W/m$^2$ pendant une durée d'environ 10 heures, tout en étant chauffée à une température comprise entre 20 °C et 200 °C. Une telle durée de traitement est incompatible avec la cadence des lignes de production actuelles de cellules photovoltaïques.

Le document CN 107 546 296 A décrit un procédé de traitement d'une couche de cellule photovoltaïque, ledit procédé comprenant une étape d'exposition d'une face de cette couche à un rayonnement électromagnétique émis par une source de rayonnement, le rayonnement électromagnétique étant appliqué par un balayage surfacique de la face de la couche, l'empilement et la source de rayonnement étant animés d'un mouvement relatif de translation dans une direction de déplacement

Il est également connu que le silicium amorphe des cellules photovoltaïques SHJ se dégrade au-delà d'une température seuil, qui peut être comprise entre 190 °C et 320 °C (suivant le mode de dépôt du silicium amorphe notamment). Une telle limite de température peut être contraignante lorsque l'irradiance du flux lumineux est importante.

**RÉSUMÉ DE L'INVENTION**

Il existe un besoin de prévoir un procédé de traitement d'un empilement qui permette, pour une valeur donnée de densité surfacique d'énergie reçue par l'empilement, de réduire l'échauffement de l'empilement.

Selon l'invention, on tend à satisfaire ce besoin en prévoyant un procédé de traitement d'un empilement obtenu lors de la fabrication d'une cellule photovoltaïque à hétérojonction, afin d'améliorer le rendement de la cellule photovoltaïque, l'empilement comprenant un substrat en silicium cristallin et une couche de passivation en silicium amorphe hydrogéné disposée sur le substrat, ledit procédé comprenant une étape d'exposition d'une face de l'empilement à un rayonnement électromagnétique émis par une source de rayonnement, le rayonnement électromagnétique étant appliqué à la face de l'empilement selon une ligne, l'empilement et la source de rayonnement étant animés d'un mouvement relatif de translation dans une direction de déplacement telle que la ligne balaye une partie au moins de la face de l'empilement.

Le balayage d'une ligne de rayonnement électromagnétique (aussi appelé balayage linéaire) provoque un échauffement global de l'empilement moindre par rapport à une exposition pleine plaque (pour une même valeur de densité surfacique d'énergie reçue par l'empilement). Le balayage linéaire implique en outre que la température de l'empilement n'est plus homogène sur toute la superficie de la face exposée. Cela offre la possibilité de restreindre l'échauffement de l'empilement au-delà d'une température seuil dite de dégradation du silicium amorphe (typiquement comprise entre 190 °C et 320 °C) à une faible portion de l'empilement, voire de le supprimer totalement. Ainsi, la dégradation du silicium amorphe de la première couche de passivation est évitée ou limitée à cette seule portion surchauffée. Le balayage linéaire est par ailleurs une façon simple et rapide de traiter l'empilement.

De préférence, la face de l'empilement comprend :

- un premier bord appelé bord d'attaque ;
- un deuxième bord appelé bord de fuite et opposé au premier bord ; et
- des troisième et quatrième bords reliant les premier et deuxième bords.

Dans un premier mode de mise en oeuvre du procédé de traitement, la ligne comprend un segment de droite orienté perpendiculairement à une médiane de la face de l'empilement, la médiane passant par le bord d'attaque et le bord de fuite.

Dans un deuxième mode de mise en oeuvre, la ligne comprend un segment de droite incliné par rapport à une médiane de la face de l'empilement d'un angle strictement inférieur à 90° en valeur absolue, la médiane passant par le bord d'attaque et le bord de fuite.

Selon un développement de ce deuxième mode de mise en oeuvre, le segment de droite est incliné par rapport à la médiane d'un angle inférieur ou égal à 50° en valeur absolue, de préférence inférieur ou égal à 20° en valeur absolue et plus préférentiellement encore inférieur ou égal à 10° en valeur absolue.

Dans un troisième mode de mise en oeuvre, la ligne est une ligne brisée comprenant un premier segment de droite incliné par rapport à une médiane de la face de l'empilement d'un premier angle positif et un deuxième segment de droite incliné par rapport à la médiane d'un deuxième angle négatif, la médiane passant par le bord d'attaque et le bord de fuite, le premier angle et le deuxième angle étant inférieurs à 90° en valeur absolue.

Selon un développement de ce troisième mode de mise en oeuvre, le premier angle et le deuxième angle sont égaux en valeur absolue.

Selon un développement du deuxième ou du troisième mode de mise en oeuvre, la ligne balaye toute la face de l'empilement exceptée une portion adjacente à l'un au moins des troisième et quatrième bords.

La portion adjacente à l'un au moins des troisième et quatrième bords occupe avantageusement moins de 40 % de la face de l'empilement.

Selon un autre mode de mise en oeuvre du procédé de traitement, la ligne balaye une partie seulement de la face de l'empilement, en commençant par le premier bord, l'étape d'exposition de la face de l'empilement au rayonnement électromagnétique étant interrompue avant que la ligne n'atteigne le deuxième bord.

La température de l'empilement augmente plus la ligne s'approche du deuxième bord de la face exposée. En stoppant l'exposition avant que la ligne n'atteigne le deuxième bord, l'échauffement de l'empilement au-delà d'une température seuil dite de dégradation du silicium amorphe peut être limité à une faible portion de l'empilement, voire supprimé totalement. Ainsi, la dégradation du silicium amorphe de la première couche de passivation est évitée ou limitée à cette seule portion surchauffée.

Avantageusement, l'étape d'exposition de la face de l'empilement au rayonnement électromagnétique est interrompue lorsque la ligne se situe à une distance du deuxième bord déterminée en fonction d'une température de dégradation du silicium amorphe.

De préférence, l'étape d'exposition est interrompue à un instant où une portion de l'empilement atteint une température de dégradation du silicium amorphe. La température de dégradation du silicium amorphe est typiquement comprise entre 190 °C et 320 °C, par exemple sensiblement égale à 200 °C.

L'étape d'exposition est de préférence interrompue à un instant où la ligne est située à une distance d du deuxième bord donnée par la relation suivante :

$$d = aV^b + c$$

où V est la vitesse de déplacement relatif entre l'empilement et la source de rayonnement et *a*, *b* et c sont des premier, deuxième et troisième coefficients.

Le premier coefficient peut être compris entre 0 et 1000, de préférence entre 5 et 50, pour une vitesse de déplacement V exprimée en cm/s et une distance d exprimée en mm.

Le deuxième coefficient peut être compris entre -10 et 0, de préférence entre -1 et -0,1.

L'étape d'exposition de la face de l'empilement au rayonnement électromagnétique peut être interrompue en arrêtant la source de rayonnement ou en bloquant le rayonnement électromagnétique, par exemple au moyen d'un obturateur.

Le procédé de traitement selon l'invention peut également présenter une ou plusieurs des caractéristiques ci-dessous, considérées individuellement ou selon toutes les combinaisons techniquement possibles.

- la ligne balaye plus de 60 % de la face de l'empilement, et de préférence moins de 100 % de la face de l'empilement ;
- la ligne balaye plus de 80 % de la face de l'empilement et moins de 100 % de la face de l'empilement ;
- la densité surfacique d'énergie reçue en tout point de la face de l'empilement est comprise entre 1 kJ/m$^2$ et 1000 kJ/m$^2$, avantageusement entre 10 kJ/m$^2$ et 100 kJ/m$^2$
- le rayonnement électromagnétique présente une irradiance supérieure ou égale à 1 kW/m$^2$, de préférence comprise entre 100 kW/m$^2$ et 5000 kW/m$^2$ ;
- l'empilement et la source de rayonnement sont en mouvement relatif de translation à une vitesse de déplacement comprise entre 1 cm/s et 100 cm/s, de préférence supérieure ou égale à 2 cm/s ;
- la ligne présente une largeur comprise entre 0,1 mm et 100 mm, de préférence comprise entre 1 mm et 10 mm ;
- l'empilement comprend en outre une couche de silicium amorphe dopé disposée sur la couche de passivation ;
- l'empilement comprend en outre une couche d'oxyde transparent conducteur disposée sur la couche de silicium amorphe dopé ;
- le substrat est en silicium cristallin dopé de type n ;
- le substrat présente une concentration en impuretés dopantes de type accepteur inférieure à 10$^{13}$ cm$^{-3}$, de préférence inférieure à 3.10$^{12}$ cm$^{-3}$ ;
- lorsque le substrat comporte des impuretés dopantes de type donneur et des impuretés dopantes de type accepteur, la concentration en impuretés dopantes de type donneur est de préférence supérieure à 50 fois la concentration en impuretés dopantes de type accepteur ;
- la source de rayonnement émet un faisceau d'ondes électromagnétiques orienté perpendiculairement à la face de l'empilement ; et
- la source de rayonnement émet un faisceau d'ondes électromagnétiques incliné par rapport à la normale de la face de l'empilement.

Le procédé de traitement selon l'invention est utilisé dans un procédé de fabrication d'une cellule photovoltaïque à hétérojonction, comprenant les étapes suivantes :

- former un empilement en déposant une couche de passivation en silicium amorphe hydrogéné sur un substrat en silicium cristallin ; et
- soumettre l'empilement au procédé de traitement selon l'invention.

**BRÈVE DESCRIPTION DES FIGURES**

D'autres caractéristiques et avantages de l'invention ressortiront clairement de la description qui en est donnée ci-dessous, à titre indicatif et nullement limitatif, en référence aux figures suivantes.

[Fig. 1] est une vue schématique en perspective d'un exemple de cellule photovoltaïque à hétérojonction.
[Fig. 2] représente schématiquement un procédé de traitement d'un empilement par balayage d'une ligne de rayonnement électromagnétique selon l'invention.
[Fig. 3] représente un premier mode de mise en oeuvre du procédé de traitement par balayage selon l'invention.
[Fig. 4] montre la température maximale atteinte dans l'épaisseur d'un empilement pour chaque point d'une face de l'empilement, lorsque cette face est entièrement balayée par le rayonnement électromagnétique au cours d'un procédé de traitement selon la figure 3.
[Fig. 5A] représente l'amplitude de la surchauffe dans une portion adjacente à un bord de fuite de l'empilement, en fonction de la vitesse de balayage du rayonnement électromagnétique.
[Fig. 5B] représente la largeur de la portion surchauffée en fonction de la vitesse de balayage du rayonnement électromagnétique.
[Fig. 6] représente un deuxième mode de mise en oeuvre du procédé de traitement par balayage selon l'invention.

[Fig. 7] montre la température maximale atteinte dans l'épaisseur de l'empilement pour chaque point de la face exposée, au cours d'un procédé de traitement selon la figure 6.

[Fig. 8] représente un troisième mode de mise en oeuvre du procédé de traitement par balayage selon l'invention.

[Fig. 9] montre la température maximale atteinte dans l'épaisseur de l'empilement pour chaque point de la face exposée, au cours d'un premier procédé de traitement selon la figure 8.

[Fig. 10] montre la température maximale atteinte dans l'épaisseur de l'empilement pour chaque point de la face exposée, au cours d'un deuxième procédé de traitement selon la figure 8.

[Fig. 11] montre la température maximale atteinte dans l'épaisseur de l'empilement pour chaque point de la face exposée, au cours d'un troisième procédé de traitement selon la figure 8.

[Fig. 12] montre la température maximale atteinte dans l'épaisseur de l'empilement pour chaque point de la face exposée, au cours d'un quatrième procédé de traitement selon la figure 8.

[Fig. 13] représente schématiquement un autre mode de mise en oeuvre du procédé de traitement selon l'invention.

[Fig. 14] montre la température maximale atteinte dans l'épaisseur de l'empilement pour chaque point de la face exposée, au cours d'un procédé de traitement selon la figure 13.

[Fig. 15] représente les températures en deux points d'un empilement et la différence de température entre ces deux points, en fonction de la densité surfacique d'énergie apportée à l'empilement, lorsque la face de l'empilement est entièrement balayée par le rayonnement électromagnétique.

[Fig. 16] représente la largeur de la portion surchauffée en fonction de la vitesse de balayage du rayonnement électromagnétique, pour différentes séries de calculs.

Pour plus de clarté, les éléments identiques ou similaires sont repérés par des signes de référence identiques sur l'ensemble des figures.

## DESCRIPTION DÉTAILLÉE

La figure 2 représente schématiquement un procédé de traitement d'un empilement 10' obtenu lors de la fabrication d'une cellule photovoltaïque à hétérojonction. Ce procédé de traitement vise à améliorer le rendement de la cellule photovoltaïque à hétérojonction. L'empilement 10' comprend au moins un substrat 11 en silicium cristallin (c-Si) et une première couche de passivation 14 disposée sur une première face 11a du substrat 11. L'empilement 10' peut être un précurseur de cellule photovoltaïque à hétérojonction, c'est-à-dire un produit intermédiaire obtenu au cours de la fabrication d'une cellule photovoltaïque à hétérojonction, ou une cellule photovoltaïque à hétérojonction finalisée (c.-à-d. prête à être interconnectée avec d'autres cellules photovoltaïques à hétérojonction).

Le silicium cristallin (c-Si) du substrat 11 est de préférence dopé de type n. Seules des impuretés dopantes de type donneur (par exemple des atomes de phosphore) ont été volontairement introduites dans le silicium cristallin afin de modifier sa conductivité électrique. Outre des impuretés dopantes de type donneur, le substrat 11 peut contenir, de façon non intentionnelle (et donc à l'état de traces), des impuretés dopantes de type accepteur (telles que des atomes de bore). La concentration en impuretés dopantes de type accepteur $N_A$ du substrat 11 est avantageusement inférieure à $10^{13}$ cm$^{-3}$, de préférence inférieure à $3.10^{12}$ cm$^{-3}$. La concentration en impuretés dopantes de type donneur $N_D$ est de préférence supérieure à 50 fois la concentration en impuretés dopantes de type accepteur $N_A$ (ou $N_D/N_A > 50$).

La première couche de passivation 14 est en silicium amorphe hydrogéné (a-Si:H). Le silicium amorphe hydrogéné de la première couche de passivation 14 est de préférence intrinsèque, c'est-à-dire non intentionnellement dopé. Le silicium amorphe hydrogéné intrinsèque permet en effet une meilleure passivation chimique des surfaces de silicium cristallin que le silicium amorphe hydrogéné dopé.

En référence à la figure 2, le procédé de traitement comprend une étape d'exposition d'une face de l'empilement 10' à un rayonnement électromagnétique 20 émis par une source de rayonnement 40. Le rayonnement électromagnétique 20 est de préférence dirigé perpendiculairement à la surface de l'empilement 10'.

L'exposition de l'empilement 10' au rayonnement électromagnétique 20 a pour effet de diminuer le nombre d'états d'interface entre le substrat cristallin 11 et la première couche de passivation 14. Autrement dit, le nombre de défauts d'interface neutralisés augmente et la qualité de la passivation s'améliore. Il en résulte une augmentation de la tension de circuit ouvert Voc et du facteur de forme (FF) de la cellule photovoltaïque comprenant l'empilement, et par conséquent une augmentation de son rendement de conversion. La valeur du gain en rendement dépend de la densité surfacique d'énergie Q reçue par l'empilement.

Le rayonnement électromagnétique 20 présente une irradiance E, appelée aussi éclairement énergétique ou densité surfacique de puissance lumineuse, qui est avantageusement supérieure ou égale à 1 kW/m$^2$, de préférence comprise entre 100 kW/m$^2$ et 5000 kW/m$^2$. L'irradiance E représente la puissance du rayonnement électromagnétique reçue par une unité de surface, cette unité de surface étant orientée perpendiculairement à la direction du rayonnement électromagnétique 20.

Une telle irradiance permet de diminuer la durée d'exposition au rayonnement électromagnétique 20, aussi appelé temps de traitement t, pour un même gain en rendement (la cinétique du gain en rendement augmente avec l'irradiance du rayonnement).

Afin d'améliorer le rendement de conversion de la cellule photovoltaïque, il n'est pas obligatoire d'exposer plus d'une face de l'empilement 10' au rayonnement électromagnétique 20. En revanche, cette face de l'empilement 10' peut être irradiée entièrement. De préférence, toutes les régions exposées de la face de l'empilement 10' reçoivent le rayonnement électromagnétique 20 pendant la même durée de traitement t.

La source de rayonnement 40 peut être un système laser comprenant par exemple une ou plusieurs matrices de lasers, un ensemble de diodes électroluminescentes ou tout autre dispositif capable d'émettre un rayonnement électromagnétique d'une irradiance supérieure à 1 kW/m$^2$.

Le rayonnement électromagnétique 20 peut être monochromatique, c'est-à-dire ne présenter qu'une seule longueur d'onde, ou polychromatique, c'est-à-dire comporter plusieurs composantes (monochromatiques) de longueurs d'ondes différentes. De préférence, le rayonnement électromagnétique 20 présente au moins une longueur d'onde comprise entre 300 nm et 1100 nm, préférentiellement entre 400 nm et 1100 nm (dans cette plage, le rayonnement est absorbé au moins en partie dans le substrat en silicium cristallin), et avantageusement entre 800 nm et 1000 nm.

La plage de longueur d'onde [800 nm-1000 nm] constitue un excellent compromis entre le flux de photons arrivant sur l'empilement 10' et la probabilité que ces photons soient absorbés par le substrat. En effet, plus la longueur d'onde est grande, moins les photons sont énergétiques et plus le flux de photons reçu par l'empilement est important à une irradiance donnée. Toutefois, la probabilité d'absorption des photons diminue fortement lorsque la longueur d'onde devient supérieure à 1000 nm. Un autre avantage à privilégier les grandes longueurs d'onde (800-1000 nm) tient au fait que les photons plus énergétiques (< 800 nm) transfèrent une partie de leur énergie sous forme de chaleur dans l'empilement, par émission de phonons. Or l'augmentation de température qui en résulte n'est pas souhaitable compte tenu du risque de dégradation du silicium amorphe.

Lors de l'étape d'exposition, aussi appelée étape d'irradiation, l'empilement 10' et la source de rayonnement 40 sont animés d'un mouvement relatif de translation (autrement dit, l'un se déplace par rapport à l'autre). Par exemple, l'empilement 10' peut être placé sur un support 30 mobile en translation et la source 40 peut être fixe. Inversement, le support 30 de l'empilement 10' peut être fixe et la source 40 mobile. L'empilement 10' et la source 40 peuvent être également tous les deux mobiles, mais pas dans la même direction et à la même vitesse.

Un tel mouvement de translation permet d'irradier une grande partie de la face de l'empilement 10' dans le cas d'une source de rayonnement 40 ayant une surface d'irradiation inférieure à la superficie de la face de l'empilement 10' (cas d'un système laser notamment). Il permet également d'irradier plusieurs empilements 10' successivement, ces empilements étant par exemple disposés sur le même support 30. Dans ce cas, il pourra être considéré que les empilements 10' défilent devant la source de rayonnement 40.

Le support 30 peut notamment être un porte-substrat ou un convoyeur capable de transporter plusieurs empilements 10' simultanément.

Le support 30 peut être en outre couplé à un système de refroidissement (non représenté), afin de diminuer la température de l'empilement 10' lors de l'étape d'exposition. Le support 30 est par exemple refroidi en faisant circuler un fluide caloporteur ou grâce à des éléments Peltier.

Outre le substrat 11 et la première couche de passivation 14, l'empilement 10' peut comprendre une deuxième couche de passivation (non représentée sur la figure 2) disposée sur une deuxième face 11b du substrat 11, opposée à la première face 11a. La deuxième couche de passivation peut être en silicium amorphe hydrogéné intrinsèque, nitrure de silicium, oxyde d'aluminium, oxyde de titane ou oxyde de silicium. A l'instar de la première couche de passivation 14, la deuxième couche de passivation contribue à réduire le nombre de recombinaisons des paires électron-trou en surface du substrat 11, augmentant ainsi le niveau d'injection dans l'empilement 10' lors de l'étape d'irradiation (et du fonctionnement ultérieur de la cellule photovoltaïque).

L'empilement 10' peut également comprendre (en présence ou non de la deuxième couche de passivation) une première couche de silicium amorphe dopé disposée sur la première couche de passivation 14, et de façon avantageuse, une couche d'oxyde transparent conducteur disposée sur la première couche de silicium amorphe dopé. Le silicium de la première couche de silicium amorphe est dopé d'un premier type de conductivité, qui peut être identique à celui du substrat 11 (par exemple de type n dans le cas d'un substrat 11 en silicium dopé de type n) ou au contraire opposé à celui du substrat 11 (ex. de type p). L'exposition au rayonnement électromagnétique 20 a alors pour effet supplémentaire d'améliorer la qualité de l'interface entre la première couche de passivation et la première couche de silicium amorphe dopé et/ou de l'interface entre la première couche de silicium amorphe dopé et la couche d'oxyde transparent conducteur.

L'empilement 10' peut également comprendre une deuxième couche de silicium amorphe dopé disposée sur la deuxième couche de passivation. Le silicium de la deuxième couche de silicium amorphe est dopé d'un deuxième type de conductivité opposé au premier type de conductivité. L'exposition au rayonnement électromagnétique 20 a alors pour effet supplémentaire d'améliorer la qualité de l'interface entre la deuxième couche de passivation et la deuxième couche de silicium amorphe dopé.

Dans un mode de mise en oeuvre du procédé de traitement, l'empilement 10' est du type représenté sur la figure 1 et comprend :

- un substrat 11 en silicium cristallin, de préférence dopé n ;
- une première couche de passivation 14 en silicium amorphe hydrogéné (et de préférence intrinsèque) disposée sur la première face 11a du substrat 11 ;
- une première couche de silicium amorphe 12, disposée sur la première couche de passivation 14 et dopée d'un premier type de conductivité ;
- une première couche d'oxyde transparent conducteur 15 disposée sur la première couche dopée de silicium amorphe 12 ;
- une deuxième couche de passivation 14 en silicium amorphe hydrogéné (et de préférence intrinsèque) disposée sur la deuxième face 11b du substrat 11 ;
- une deuxième couche de silicium amorphe 13, disposée sur la deuxième couche de passivation 14 et dopée d'un deuxième type de conductivité opposé au premier type de conductivité ; et
- une deuxième couche d'oxyde transparent conducteur 15 disposée sur la deuxième couche dopée de silicium amorphe 13.

Un tel empilement ou précurseur de cellule photovoltaïque à hétérojonction est qualifié d'asymétrique en raison des deux couches de silicium amorphe 12-13 dopées de types de conductivité opposés et disposées de part et d'autre du substrat 11. Le silicium amorphe de la première couche dopée 12 et/ou de la deuxième couche dopée 13 est de préférence hydrogéné.

Lorsqu'un empilement du type de la figure 1 est exposé au rayonnement électromagnétique 20, une diminution de la résistance série de la cellule photovoltaïque est en outre observée.

Quel que soit l'empilement utilisé, la première face 11a du substrat 11 (recouverte de la première couche de passivation 14) peut être tournée vers la source de rayonnement 40, comme cela illustré par la figure 2. Alternativement, la deuxième face 11b du substrat 11 peut être tournée vers la source de rayonnement 40.

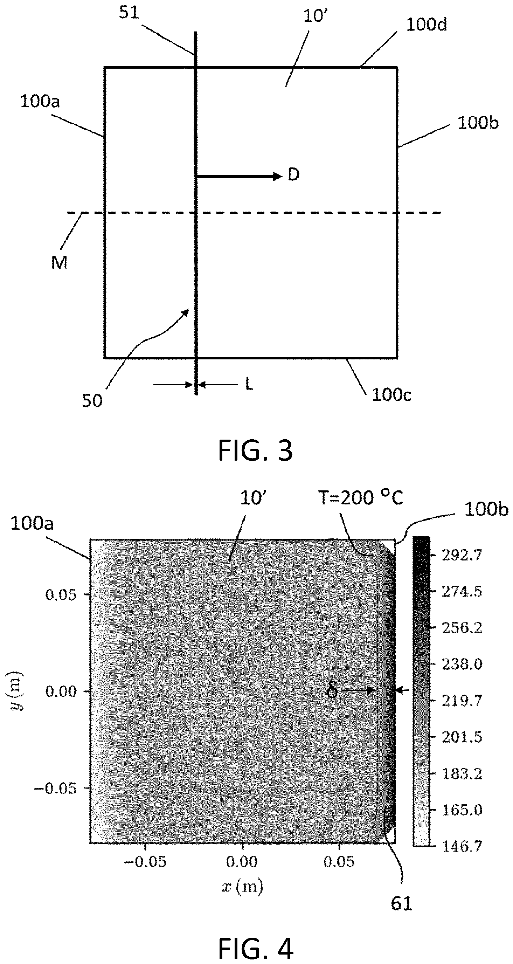

Les figures 3, 6 et 8 représentent différents modes de mise en oeuvre du procédé de traitement d'un empilement 10'.

La face exposée de l'empilement 10' comprend :

- un premier bord 100a appelé bord d'attaque, défini comme étant le bord à passer en premier devant la source de rayonnement 40 ;
- un deuxième bord 100b appelé bord de fuite, opposé au premier bord 100a et défini comme étant le bord à passer en dernier devant la source de rayonnement 40 ; et
- des troisième et quatrième bords 100c-100d dits transversaux (bords inférieur et supérieur sur les figures) qui relient les premier et deuxième bords 100a-100b.

La face exposée de l'empilement 10' présente de préférence une forme carrée, pseudo-carrée (angles tronqués) ou rectangulaire. Le bord d'attaque 100a et le bord de fuite 100b sont ainsi parallèles entre eux, tout comme les bords transversaux 100c-100d.

D'une manière commune à tous les modes de réalisation, la source de rayonnement 40 est configurée de sorte que le rayonnement électromagnétique 20 soit appliqué à la face de l'empilement 10' selon une ligne 50. Autrement dit, la surface de l'empilement 10' irradiée par la source de rayonnement 40 (appelée surface d'irradiation) à un instant donné du procédé de traitement est en forme de ligne. La ligne 50 présente une largeur L qui peut être comprise entre 0,1 mm et 100 mm, de préférence entre 1 mm et 10 mm.

La ligne 50 peut comprendre un ou plusieurs segments de droite 51, 51' 52a-52b. Les segments de droite peuvent être connectés, formant ainsi une ligne brisée, ou au contraire être disjoints. La ligne 50 est ainsi l'intersection d'un faisceau d'ondes électromagnétiques généré par la source de rayonnement 40 avec la surface de l'empilement 10', les rayons du faisceau étant contenus dans un ou plusieurs plans (sécants ou non).

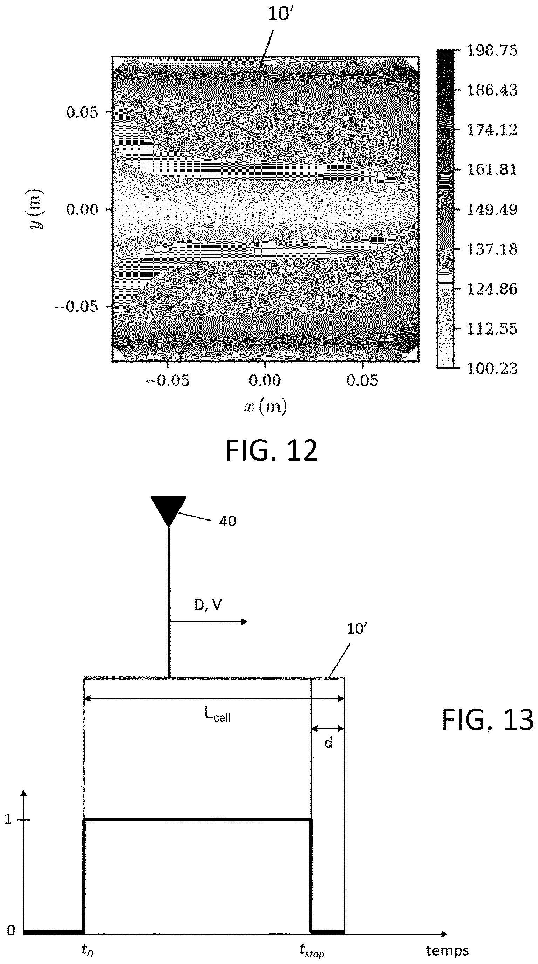

La direction D du déplacement relatif entre l'empilement 10' et la source de rayonnement 40 est telle que la ligne 50 balaye une partie au moins de la face de l'empilement 10' lors du procédé de traitement. La ligne 50 balaye la face de l'empilement 10' en commençant par le bord d'attaque 100a puis en se dirigeant vers le bord de fuite 100b. Elle peut atteindre (et même dépasser) le bord de fuite 100b ou au contraire s'arrêter avant d'atteindre le bord de fuite 100b (cf. Fig.13). De préférence, la ligne 50 balaye plus de 60 % de la face exposée de l'empilement 10'.

La direction de déplacement D de la source de rayonnement 40 par rapport à l'empilement 10', aussi appelée direction de balayage D, est par exemple perpendiculaire au bord d'attaque 100a et au bord de fuite 100b, comme cela est représenté sur les figures 3, 6 et 8.

La vitesse V du déplacement relatif entre l'empilement 10' et la source de rayonnement 40 est de préférence choisie de façon à traiter un empilement 10' par balayage du rayonnement électromagnétique en un temps t court, typiquement compris entre 0,1 s et 30 s. La vitesse de déplacement V est avantageusement comprise entre 1 cm/s et 100 cm/s, et de préférence supérieure ou égale à 2 cm/s.

Ce traitement par balayage est simple et rapide à mettre en oeuvre. En faisant défiler en continu les empilements 10' (précurseurs de cellule photovoltaïque ou cellules photovoltaïques) devant la source de rayonnement 40, le procédé de traitement peut être accompli à une cadence élevée, compatible avec les exigences de production industrielle des cellules photovoltaïques.

A titre d'exemple, en considérant une vitesse de déplacement V comprise entre 1 cm/s et 100 cm/s et des empilements 10' dont les faces principales mesurent 156 mm par 156 mm, le temps de traitement t d'un empilement 10' est compris entre 0,156 s et 15,6 s. Le nombre d'empilements 10' traités par heure peut être compris entre 200 et 25000.

Pour une valeur donnée de densité surfacique d'énergie Q, l'exposition par balayage linéaire provoque un échauffement moindre qu'une exposition simultanée de toute la face de l'empilement (exposition « pleine plaque » statique ou par balayage surfacique). En effet, la surface sur laquelle est appliqué le rayonnement (à un instant t) est réduite et une diffusion de la chaleur dans les zones non soumises au rayonnement se produit. Par ailleurs, le balayage linéaire offre la possibilité de limiter l'échauffement de l'empilement à une température supérieure à la température de dégradation du silicium, par exemple 200 °C, à une faible portion de l'empilement (contrairement à l'exposition pleine plaque), et dans certaines conditions de le supprimer totalement. Ainsi, la dégradation du silicium amorphe de la première couche de passivation 14 peut être évitée ou limitée à cette seule portion surchauffée. Il n'est alors pas obligatoire de procéder à un refroidissement de l'empilement 10', par exemple au moyen d'un système de refroidissement ou lors d'une interruption de l'exposition. De préférence, la portion surchauffée occupe moins de 40 % de la face exposée de l'empilement 10'.

Le procédé de traitement peut être caractérisé par les paramètres suivants :

- E : l'irradiance du rayonnement électromagnétique 20 (en kW/m$^2$) ;
- V : la vitesse de déplacement relatif entre l'empilement 10' et la source de rayonnement 40, aussi appelée vitesse de balayage du rayonnement électromagnétique (en cm/s) ;
- L : la largeur de la ligne 50 (en mm) ; et
- e : l'épaisseur de l'empilement 10' (en $\mu$m).

La densité surfacique d'énergie Q (en kJ/m$^2$), ou énergie surfacique, reçue en tout point de la face de l'empilement par rayonnement électromagnétique est définie par la relation suivante :

[Math. 1]

$$Q = (E * L)/(10 * V)$$

Les paramètres E, V et L sont de préférence choisis pour obtenir une densité surfacique d'énergie Q comprise entre 1 kJ/m$^2$ et 1000 kJ/m$^2$, avantageusement entre 10 kJ/m$^2$ et 100 kJ/m$^2$. Les plages de valeurs données ci-dessus pour l'irradiance E du rayonnement électromagnétique 20, la vitesse de balayage V et la largeur L de la ligne 50 sont suffisamment larges pour y parvenir.

Par ailleurs, pour une combinaison des paramètres E, V et L donnée, des simulations thermiques ont montré que les niveaux de température observés dans l'empilement dépendent de son épaisseur e. Plus l'épaisseur e de l'empilement est faible et plus les températures sont élevées, car la densité volumique d'énergie absorbée augmente. Tous les résultats de simulation présentés ci-après ont été obtenus avec une épaisseur d'empilement e égale à 160 $\mu$m.

Dans un premier mode de mise en oeuvre illustré par la figure 3, la ligne 50 comprend un segment de droite 51 orienté perpendiculairement à une médiane M de la face exposée de l'empilement 10'. La médiane M est le segment de droite qui relie les milieux du bord d'attaque 100a et du bord de fuite 100b. Elle est de préférence perpendiculaire au bord d'attaque 100a et au bord de fuite 100b. De préférence, la source de rayonnement est dimensionnée pour que la ligne 50 irradie toute la largeur de l'empilement 10'.

La figure 4 est une cartographie de la température maximale atteinte dans un empilement 10' (dont les faces principales sont pseudo-carrées : 156 mm x 156 mm) au cours d'un procédé de traitement selon la figure 3. Elle a été obtenue au moyen d'une simulation thermique du procédé de traitement par balayage. Dans cette première simulation comme dans les suivantes (sauf précisions contraires), l'irradiance E du rayonnement électromagnétique est égale à 216 kW/m$^2$, la vitesse de balayage V est égale à 2,48 cm/s et la largeur de la ligne 50 est égale à 6 mm. La courbe isotherme T = 200 °C est représentée en traits pointillés.

Cette cartographie montre que la température maximale de l'empilement au cours du traitement est supérieure à 200 °C uniquement dans une portion 61 adjacente au bord de fuite 100b de l'empilement (c.-à-d. le bord exposé en dernier au rayonnement électromagnétique 20). En dehors de cette portion 61 dite surchauffée, la température maximale de l'empilement 10' est inférieure à 200 °C. On constate également que la température est la plus faible à proximité du bord d'attaque 100a (exposé en premier au rayonnement électromagnétique 20).

La dégradation du silicium amorphe sous l'effet de la température est donc limitée à la portion surchauffée 61 située au voisinage du bord de fuite 100b. La dégradation du silicium amorphe diminue les performances de la cellule photovoltaïque à hétérojonction dans la portion surchauffée 61. En revanche, le traitement par balayage améliore les performances de la cellule photovoltaïque partout ailleurs, soit dans une majeure partie de l'empilement (occupant typiquement plus de 90 % de la face exposée de l'empilement).

La surchauffe locale près du bord de fuite 100b s'explique par la formation d'une couche limite thermique à l'avant du faisceau. Cette couche limite thermique est liée à la diffusion de chaleur et se propage dans l'empilement depuis le bord d'attaque 100a jusqu'au bord de fuite 100b. A l'approche du bord de fuite 100b, la chaleur ne peut plus se diffuser vers l'avant du faisceau, ce qui provoque la surchauffe.

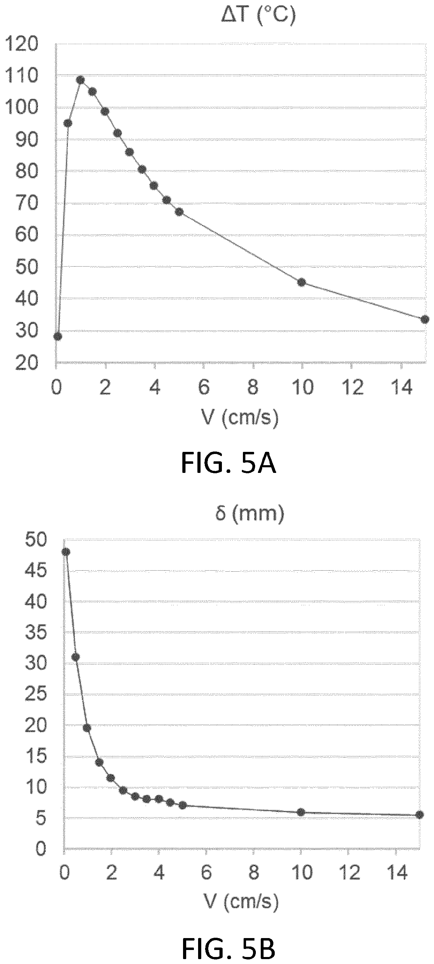

La figure 5A est un graphique représentant l'amplitude $\Delta T$ de la surchauffe dans la portion surchauffée 61 en fonction de la vitesse de balayage du rayonnement électromagnétique. L'amplitude $\Delta T$ de la surchauffe correspond à la différence de températures entre le point le plus chaud dans la portion surchauffée 61 et le point situé au centre de la face exposée, en $(x,y)=(0,0)$.

La figure 5B est un graphique représentant la largeur $\delta$ de la portion surchauffée 61 en fonction de la vitesse de balayage du rayonnement électromagnétique. La largeur $\delta$ de la portion surchauffée 61 est mesurée depuis le bord de fuite 100b de l'empilement 10', perpendiculairement à ce bord et sur la médiane M de la face de l'empilement (à $y=0$).

Ces deux figures montrent que, pour une densité surfacique d'énergie donnée (ici 60 kJ/m$^2$), l'amplitude $\Delta T$ de la surchauffe et la largeur $\delta$ de la portion surchauffée 61 diminuent lorsque la vitesse de balayage augmente (à partir d'une vitesse de balayage d'environ 2 cm/s pour l'amplitude $\Delta T$).

Afin de limiter la dégradation du silicium amorphe et la diminution des performances de la cellule photovoltaïque qui en résulte, la vitesse de balayage V est avantageusement choisie supérieure ou égale à 2 cm/s. De manière générale, la portion surchauffée 61 s'étend sur toute la longueur du bord de fuite 100b et présente une largeur sensiblement constante. La largeur $\delta$ de la portion surchauffée 61 est typiquement comprise entre 1 mm et 30 mm. La portion surchauffée 61 représente avantageusement jusqu'à 20 % de la superficie de la face exposée de l'empilement.

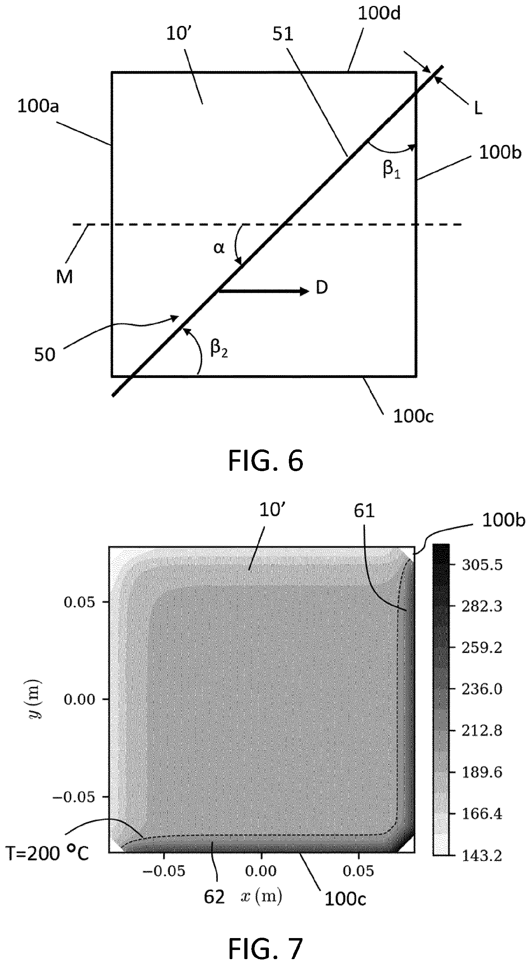

Dans un deuxième mode de mise en oeuvre représenté par la figure 6, la ligne 50 comprend un segment de droite 51' incliné par rapport à la médiane M d'un angle $\alpha$ (non-nul) strictement inférieur à 90° en valeur absolue, et de préférence inférieur ou égal à 50° en valeur absolue. L'angle $\alpha$ désigne le plus petit angle mesurable entre la ligne 50 et la médiane M. Il peut être positif ou négatif.

L'inclinaison de la ligne 50 par rapport à la médiane M a pour effet de déplacer une partie au moins de la surchauffe vers l'un des deux bords transversaux 100c-100d de l'empilement 10' et de limiter son amplitude $\Delta T$ en tout point de l'empilement 10'. La dégradation du silicium amorphe est donc globalement plus faible dans le deuxième mode de mise en oeuvre du procédé (Fig.6) que dans le premier mode de mise en oeuvre (Fig.3).

La figure 7 est une autre cartographie de la température maximale atteinte dans l'empilement, obtenue par simulation thermique du procédé de traitement selon la figure 6 en prenant pour exemple un angle $\alpha$ positif et égal à 45°.

Dans cet exemple, la surchauffe (T>200 °C) se produit dans la portion 61 adjacente au deuxième bord 100b (bord de fuite) et dans une portion 62 adjacente au troisième bord 100c (bord transversal inférieur). Lorsque l'angle $\alpha$ est de 45° environ, la surchauffe est maximale dans le coin qui relie les bords 100b-100c (le coin inférieur droit sur la figure 7). La ligne 50 forme avec chacun de ces deux bords 100b, 100c un angle $\beta_1$, $\beta_2$ égal à 45° (cf. Fig.6).

De manière plus générale, un angle $\alpha$ compris entre 40° et 50° en valeur absolue permet de réduire la surchauffe au niveau des bords de l'empilement et de la concentrer dans un coin de l'empilement, autrement dit dans une zone moins critique pour les performances de la cellule photovoltaïque.

L'angle $\alpha$ est avantageusement inférieur ou égal à 20° en valeur absolue et de façon encore plus avantageuse inférieur ou égal à 10°.

Un angle $\alpha$ compris entre 10° et 20° en valeur absolue restreint la surchauffe à un coin de l'empilement 10' et à une portion de l'empilement 10' adjacente à l'un des deux bords transversaux 100c-100d.

Un angle $\alpha$ inférieur ou égal à 10° en valeur absolue restreint la surchauffe uniquement à la portion de l'empilement 10' adjacente à l'un des deux bords transversaux 100c-100d.

Lorsque la surchauffe est majoritairement localisée au niveau d'un bord transversal ($\alpha \leq 20°$), elle peut être partiellement ou complètement évitée en n'irradiant pas la portion adjacente au bord transversal. Une exposition partielle de la face de l'empilement 10' au rayonnement électromagnétique 20 est de façon générale préférable à une exposition totale accompagnée d'une surchauffe locale. Ainsi, la source de rayonnement 40 peut être configurée pour que la surface balayée lors du procédé de traitement représente plus de 60 % et moins de 100 % de la superficie de la face exposée au rayonnement électromagnétique. L'exposition partielle de la face de l'empilement 10' peut être obtenu en jouant sur le dimensionnement de la ligne 50, sur le positionnement de la source de rayonnement 40 par rapport à l'empilement 10' ou en intégrant un masque à la source de rayonnement 40.

Le fait d'incliner la ligne 50 par rapport à la médiane M rend possible une suppression de la surchauffe (en n'exposant pas la portion adjacente au bord transversal) sans toutefois interrompre la source de rayonnement 40, contrairement à la configuration de la figure 3 où la ligne 50 est perpendiculaire à la médiane M. Cette solution est particulièrement bénéfique dans le cas d'un procédé de traitement en continu des empilements 10', car elle évite de prévoir une synchronisation entre l'arrêt de la source de rayonnement et l'arrêt du déplacement, et d'accélérer le vieillissement de la source de rayonnement (consécutif aux arrêts répétés).

Ainsi, plus l'angle $\alpha$ est faible, plus la surchauffe est déplacée vers l'un des deux bords transversaux 100c-100d et plus il est facile d'éviter la dégradation du silicium amorphe. Les largeurs des portions surchauffées 61, 62 de l'empilement 10' dépendent de l'angle d'inclinaison $\alpha$ de la ligne 50 et de la vitesse de balayage V. Elles sont typiquement comprises entre 1 mm et 30 mm (et peuvent être différentes).

L'utilisation d'un angle $\alpha$ différent de 90° requiert une ligne 50 de plus grande longueur pour balayer la même surface de l'empilement 10'. La longueur de la ligne 50 dans le deuxième mode de mise en oeuvre du procédé de traitement est avantageusement égale à la longueur de la ligne 50 du premier mode de mise en oeuvre multipliée par un coefficient égal à 1/sin($\alpha$). Cette augmentation est sans incidence sur la cadence du procédé de traitement puisque plusieurs empilements 10' peuvent défiler les uns à la suite des autres sous le même faisceau.

Au contraire, l'inclinaison de la ligne 50 peut constituer une opportunité pour augmenter la cadence du procédé de traitement. En effet, en considérant une ligne 50 de largeur L constante et une direction de balayage D parallèle aux bords transversaux 100c-100d de l'empilement (comme sur les figures 3, 6 et 8), chaque point traité de la face de l'empilement 10' est irradié pendant un temps t = L/[V*sin($\alpha$)]. Pour obtenir la même densité d'énergie Q = E*t que dans le premier mode de mise en oeuvre, la vitesse de balayage V peut être multipliée par un coefficient 1/sin($\alpha$) (les autres paramètres étant inchangés). Alternativement, l'irradiance E du rayonnement électromagnétique 20 peut être multipliée par un coefficient sin($\alpha$) (les autres paramètres étant inchangés).

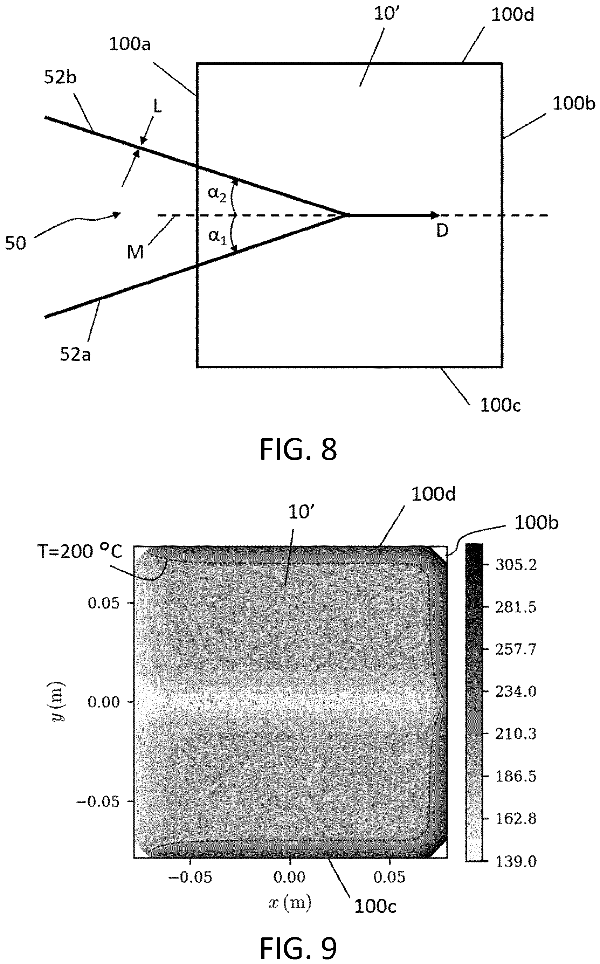

La figure 8 représente un troisième mode de mise en oeuvre du procédé de traitement dans lequel la ligne 50 est une ligne brisée. La ligne 50 comprend un premier segment de droite 52a incliné par rapport à la médiane M d'un premier angle (strictement) positif $\alpha_1$ et un deuxième segment de droite 52b incliné par rapport à la médiane M d'un deuxième angle (strictement) négatif $\alpha_2$. Le premier angle $\alpha_1$ et le deuxième angle $\alpha_2$ sont des angles non-nuls inférieurs à 90° en valeur absolue. La ligne 50 présente alors une forme de flèche.

Une ligne 50 en forme de flèche permet de déplacer au moins en partie la surchauffe du bord de fuite 100b vers les deux bords transversaux 100c-100d de l'empilement, au lieu d'un seul de ces bords dans le deuxième mode de mise en oeuvre (Fig.6).

A l'instar de l'angle $\alpha$, chacun des angles $\alpha_1$ et $\alpha_2$ est de préférence inférieur ou égal à 50° en valeur absolue, avantageusement inférieur ou égal à 20° en valeur absolue, et de façon encore plus avantageuse, inférieur ou égal à 10° en valeur absolue.

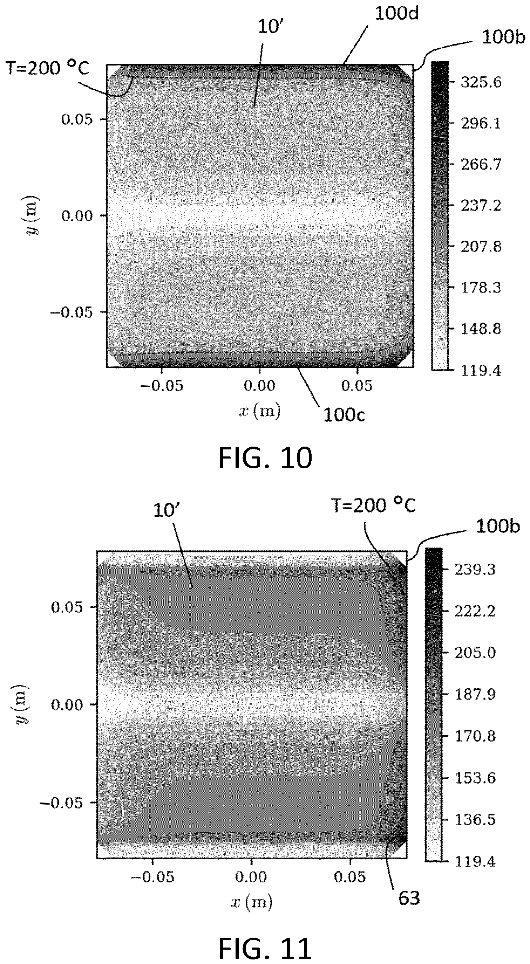

Les figures 9 et 10 sont des cartographies de la température maximale dans l'empilement 10' obtenues par simulation thermique du procédé de traitement selon la figure 8, respectivement lorsque les angles $\alpha_1$ et $\alpha_2$ valent tous les deux 45° et 20°.

Lorsque les angles $\alpha_1$ et $\alpha_2$ sont compris entre 40° et 50°, par exemple égaux à 45° (cf. Fig.9), la surchauffe (T>200 °C) se situe le long du bord de fuite 100b et le long des deux bords transversaux 100c-100d. Elle est maximale dans les deux coins situés aux extrémités du bord de fuite 100b (coins inférieur et supérieur droits).

Lorsque les angles $\alpha_1$ et $\alpha_2$ sont compris entre 10° et 20° (cf. Fig.10), la surchauffe (T>200 °C) se situe presque exclusivement le long des deux bords transversaux 100c-100d et dans les deux coins situés aux extrémités du bord de fuite 100b.

Les figures 11 et 12 montrent d'autres résultats de simulation thermique du procédé de traitement selon la figure 8, respectivement lorsque les angles $\alpha_1$ et $\alpha_2$ valent tous les deux 20° et 10°. Dans ces deux exemples, la face de l'empilement est entièrement balayée par le rayonnement électromagnétique, à l'exception de deux portions adjacentes aux bords transversaux 100c-100d (la surface irradiée est limitée à -7 cm < y < +7 cm). Les portions non-irradiées de la face de l'empilement sont des bandes de largeur constante (ici égale à 8 mm).

Dans le cas où les angles $\alpha_1$ et $\alpha_2$ sont de 20°, la surchauffe est quasiment supprimée. Seules subsistent deux portions 63 de faible superficie à proximité des deux coins de l'empilement 10'.

Dans le cas où les angles $\alpha_1$ et $\alpha_2$ sont de 10°, la surchauffe est entièrement supprimée. Autrement dit, la température de l'empilement 10' reste inférieure à 200 °C bien qu'une grande proportion de la face de l'empilement ait été balayée (ici environ 90 %)

Le premier angle $\alpha_1$ et le deuxième angle $\alpha_2$ peuvent ne pas être égaux en valeur absolue. Néanmoins, lorsqu'ils sont égaux, le traitement de l'empilement 10' est symétrique, comme illustré par les cartographies de température des figures 9 à 12.

Lorsqu'elle s'étend le long de plusieurs bords (comme sur les figures 7, 9 et 10), la portion surchauffée peut représenter jusqu'à 40 % de la superficie de la face exposée de l'empilement (typiquement jusqu'à 20 % sur chaque bord dans le cas de la figure 10).

Les résultats de simulation thermique, notamment ceux de la figure 5B, mettent en évidence que la largeur $\delta$ de la portion surchauffée 61 est principalement gouvernée par la vitesse de balayage V. La largeur $\delta$ de la portion surchauffée 61 peut être exprimée par une loi de puissance de la forme suivante :

[Math. 2]

$$\delta = aV^b$$

où V est la vitesse de balayage et a et b sont des premier et deuxième coefficients (et plus particulièrement des nombres réels).

Afin de limiter la dégradation du silicium amorphe et la diminution des performances de la cellule photovoltaïque qui en résulte, l'exposition de la face de l'empilement 10 au rayonnement électromagnétique peut être également interrompue avant que la ligne 50 n'atteigne le bord de fuite 100b de la face de l'empilement. Dans ce cas, la ligne 50 comprend de préférence un segment de droite orienté perpendiculairement à une médiane M de la face exposée de l'empilement 10' (et donc parallèlement au bord de fuite 100b).

La face de l'empilement 10' peut cesser d'être irradiée à l'approche du bord de fuite 100b soit en arrêtant la source de rayonnement 40 (et donc l'émission du rayonnement électromagnétique 20), soit en bloquant le rayonnement électromagnétique 20 émis en continu (c'est-à-dire en l'empêchant d'atteindre l'empilement), par exemple au moyen d'un obturateur.

Lorsque plusieurs empilements 10' sont exposés successivement, les arrêts répétés de la source de rayonnement 40 peuvent accélérer son vieillissement, voire l'endommager. Dans ce cas, il peut être préférable d'utiliser un obturateur ou tout autre dispositif capable de bloquer le rayonnement électromagnétique 20. Le dispositif de blocage peut être intégré à la source de rayonnement 40 ou au contraire séparé et disposé entre l'empilement 10' et la source de rayonnement 40.

Avantageusement, l'étape d'exposition est interrompue lorsque la ligne 50 se situe à une distance d du bord de fuite 100b qui est déterminée en fonction d'une température seuil dite de dégradation du silicium. Cette distance peut être déterminée par une simulation thermique (préalablement à la mise en oeuvre du procédé) ou par une mesure en continu de la température de l'empilement (au cours du procédé). La température de dégradation du silicium peut être comprise entre 190 °C et 320 °C, suivant le mode de dépôt du silicium amorphe. Elle est par exemple sensiblement égale à 200 °C. Par « sensiblement égale à 200 °C, on entend 200 °C à 5 % près (200 °C $\pm$ 5 %).

Dans un mode de mise en oeuvre préférentiel représenté schématiquement par la figure 13, l'exposition de la face de l'empilement 10' commence à un instant $t_0$ et prend fin à un instant $t_{stop}$ lorsque la ligne 50 est située à une distance d=$\delta$+c du bord de fuite 100b, $\delta$ étant la largeur de la portion surchauffée 61 qui serait obtenue si le balayage se poursuivait jusqu'au bord de fuite 100b et c un troisième coefficient (un nombre réel) permettant d'introduire une marge d'erreur. Autrement dit, l'exposition est interrompue juste avant l'apparition de la portion surchauffée 61. La distance d est typiquement comprise entre 0,1 mm et 100 mm. Elle est mesurée perpendiculairement au bord de fuite 100b.

Le troisième coefficient c permet d'ajuster la distance d entre 0 et $L_{cell}$, où $L_{cell}$ est la largeur de l'empilement 10' (par exemple 156 mm), et de préférence entre 0,1 mm et 100 mm. Il peut être compris entre -$\delta$ et -$\delta$+$L_{cell}$ (bornes non comprises), de préférence entre -$\delta$+0,1 et -$\delta$+100. Une valeur négative permet d'irradier une plus grande surface de l'empilement, avec une température de l'empilement pouvant excédent la température seuil.

La relation $\delta(V)$ entre la largeur $\delta$ (en mm) de la portion surchauffée 61 et la vitesse de balayage V (en cm/s) permet de définir une loi de commande simple pour l'interruption de l'exposition. Connaissant la largeur $L_{cell}$ (en mm) de l'empilement 10' à traiter, il est possible de déterminer l'instant $t_{stop}$ (en s) auquel l'exposition est interrompue en utilisant la relation suivante :

[Math. 3]

$$t_{stop} = t_0 + [L_{cell} - d(V)]/(10 * V)$$

avec $t_0$ (en s) l'instant auquel le faisceau irradie le bord d'attaque 100a de la face de l'empilement.

La largeur $L_{cell}$ de l'empilement 10' est définie comme la distance séparant le bord d'attaque 100a et le bord de fuite 100b. Elle est mesurée perpendiculairement à ces deux bords.

De façon plus générale, l'exposition est avantageusement interrompue à l'instant ($t_{stop}$) où une portion de l'empilement 10 atteint la température seuil de dégradation du silicium amorphe.

Ainsi, le traitement par balayage avec interruption améliore les performances de la cellule photovoltaïque dans une grande portion de l'empilement tout en réduisant de façon significative la dégradation du silicium amorphe. La portion exposée au rayonnement électromagnétique occupe avantageusement plus de 80 % de la face de l'empilement 10'.

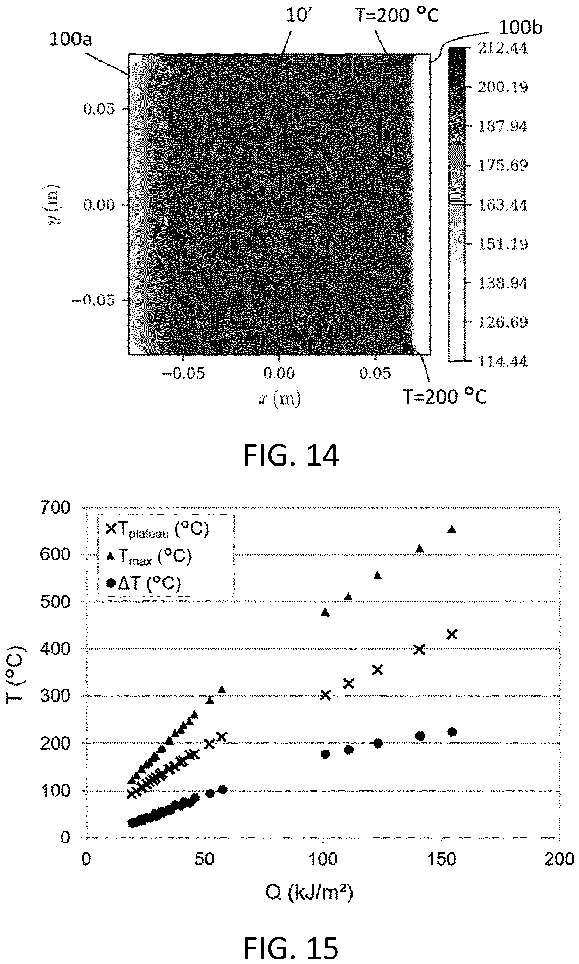

La figure 14 est une autre cartographie de la température maximale atteinte dans l'empilement, obtenue par simulation thermique du procédé de traitement selon la figure 13. Dans cette nouvelle simulation, l'irradiation est interrompue à une distance d du bord de fuite égale à 8 mm. Les paramètres de la simulation, à savoir l'irradiance E du rayonnement électromagnétique, la vitesse de balayage V et la largeur de la ligne 50, sont les mêmes que ceux employés dans la première simulation.

Cette figure montre que la température maximale au sein de l'empilement 10' n'excède pratiquement pas 200°. La portion surchauffée est réduite à deux zones très peu étendues près des angles tronqués. Partant du bord d'attaque 100a à environ 160 °C, la température au niveau de la médiane M augmente progressivement pour atteindre une température dite de plateau de l'ordre de 195 °C, puis diminue brusquement à environ 8 mm de bord de fuite 100b jusqu'à atteindre environ 115 °C. La portion exposée occupe dans cet exemple environ 95 % de la face de l'empilement 10'.

La figure 15 montre les résultats d'autres simulations thermiques du procédé de traitement selon la figure 3, accomplies avec le même empilement mais en faisant varier l'irradiance E du rayonnement électromagnétique entre 155 kW/m$^2$ et 237 kW/m$^2$ et la vitesse de balayage V entre 0,92 cm/s et 4,82 cm/s. Dans ces simulations, la ligne 50 balaye toute la superficie de la face de l'empilement. La température de plateau $T_{plateau}$ au centre de l'empilement (en x = y = 0), la température maximale $T_{max}$ atteinte au bord de fuite 100b et la différence de température $\Delta T$ entre la température maximale $T_{max}$ et la température de plateau $T_{plateau}$ ($\Delta T = T_{max} - T_{plateau}$) sont représentées en fonction de la densité surfacique d'énergie Q résultant des paramètres de simulation choisis.

On constate que la température de plateau $T_{plateau}$ au centre de l'empilement (en x = y = 0) et la température maximale $T_{max}$ augmentent avec la densité surfacique d'énergie Q apportée à l'empilement 10'.

Dans le procédé de traitement par balayage selon l'invention, il est choisi de préférence une valeur de densité surfacique d'énergie Q la plus élevée possible tout en conservant une température de plateau $T_{plateau}$ inférieure ou égale à la température seuil. Pour déterminer la densité surfacique d'énergie Q, il est avantageusement tenu compte de l'épaisseur e et de l'environnement de l'empilement 10', notamment de la présence ou non d'un système de refroidissement.

Une fois la densité surfacique d'énergie Q déterminée, les paramètres E, V et L sont déterminés afin d'assurer une mise en oeuvre optimale du procédé de traitement. Une vitesse de balayage V élevée permet par exemple de réduire la durée de traitement t et, dans le mode de mise en oeuvre de la figure 13, la distance d=δ+c à laquelle l'exposition au rayonnement électromagnétique prend fin (et donc la portion de l'empilement 10' qui n'est pas traitée). La vitesse de balayage V est avantageusement choisie supérieure ou égale à 2 cm/s.

Une campagne de simulations thermiques a été menée afin de déterminer le premier coefficient a et le deuxième coefficient b de la relation δ(V) (cf. Math. 2). La campagne de simulation comprend plusieurs séries de calculs effectuées en prenant différentes valeurs pour les paramètres Q, E, V, L et e du procédé de traitement. Ces valeurs sont données par le tableau 1 ci-dessous pour chacune des séries.

[Tableau 1]

| Série | Q (kJ/m$^2$) | V (cm/s) | E (kW/m$^2$) | L (mm) | e (μm) |
|---|---|---|---|---|---|
| Q1 | 60 | de 0,1 à 100 | de 10 à 10000 | 6 | 160 |
| Q2 | 10 | de 0,1 à 100 | de 1,67 à 1670 | 6 | 160 |
| Q3 | 200 | de 0,1 à 100 | de 33,3 à 33333 | 6 | 160 |
| L1 | 60 | de 0,1 à 100 | de 3 à 3000 | 20 | 160 |
| L2 | 60 | de 0,1 à 100 | de 60 à 60000 | 1 | 160 |
| e1 | 52,3 | 2,48 | 216 | 6 | de 60 à 160 |
| M1 | de 19,3 à 155 | de 0,92 à 4,82 | de 155 à 237 | 6 | 160 |

Dans chacune des séries 'Q1', 'Q2', 'Q3', 'L1' et 'L2', il est fait varier la vitesse de balayage V entre 0,1 cm/s à 100 cm/s. L'irradiance E est ajustée en fonction de la vitesse V selon la relation Math. 1 ci-dessus afin d'obtenir la valeur de densité Q indiquée. Pour ces cinq séries, différentes valeurs de coefficients a et b ont donc été obtenues par régression linéaire (dans un espace logarithmique).

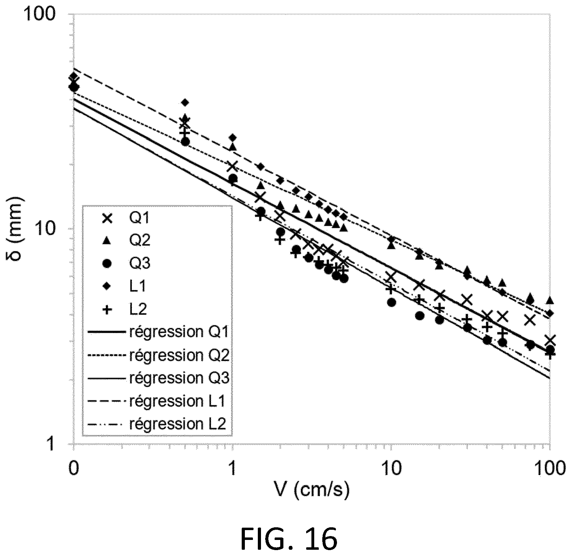

La figure 16 montre les résultats de ces cinq séries de calculs et les régressions linéaires associées. Les valeurs correspondantes des coefficients a et b, ainsi que l'erreur relative maximale entre les valeurs de $\delta$ observées dans les simulations et celles prédites par régression linéaire, sont données dans le tableau 2 ci-dessous.

[Tableau 2]

| Série | a | b | Erreur (%) |
|-------|------|--------|------------|
| Q1 | 16,2 | -0,393 | 31 |
| Q2 | 19,6 | -0,343 | 25 |
| Q3 | 13,9 | -0,418 | 27 |
| L1 | 22,8 | -0,388 | 23 |
| L2 | 14,2 | -0,406 | 33 |

Les valeurs des coefficients a et b sont données pour V en cm/s et $\delta$ en mm.

Pour les cinq séries, le premier coefficient a varie entre 13 et 23 environ, le deuxième coefficient b varie entre -0,34 et -0,42 et l'erreur relative maximale est inférieure à 33 %.

La loi de commande ci-dessus est suffisamment simple et robuste pour être appliquée dans un procédé industriel. L'ajustement des coefficients a et b en fonction des paramètres Q et L peut être réalisé empiriquement ou à l'aide d'autres simulations numériques.

De manière générale, le premier coefficient a peut être compris entre 0 et 1000, de préférence entre 5 et 50, et le deuxième coefficient b peut être compris entre -10 et 0, de préférence entre -1 et -0,1.

La série de calculs 'e1' montre l'influence de l'épaisseur e de l'empilement 10', dans un procédé de traitement de référence. Pour une épaisseur e variant de 60 $\mu$m à 160 $\mu$m, la largeur $\delta$ de la portion surchauffée varie de 10 %. La loi de commande définie pour une valeur e donnée peut donc être raisonnablement appliquée pour une autre épaisseur comprise dans la gamme 60 $\mu$m-160 $\mu$m. Alternativement, les coefficients a et b peuvent être ajustés en fonction de l'épaisseur e de l'empilement.

Enfin, la série 'M1' regroupe des simulations correspondant à différentes configurations du procédé de traitement testées expérimentalement. Dans ces essais, la densité d'énergie Q est comprise entre 19,3 kJ/m$^2$ et 155 kJ/m$^2$. L'erreur relative entre les valeurs de largeur $\delta$ simulées dans la série 'M1' et celles calculées par régression linéaire en utilisant les coefficients a et b obtenus pour la série 'Q1' (Q = 60 kJ/m$^2$) est inférieure à 15 %. Ce résultat confirme que pour les valeurs envisagées de densité d'énergie Q et de vitesse de balayage V, l'ajustement des coefficients a et b en fonction de la densité d'énergie Q ne peut apporter qu'un gain faible sur la précision de la loi de commande.

Le procédé de traitement décrit ci-dessus en relation avec les figures 3, 6, 8 et 13 peut être accompli à différents stades de la fabrication d'une cellule photovoltaïque à hétérojonction. Cette cellule photovoltaïque peut être une cellule monofaciale ou bifaciale. Dans une cellule monofaciale, seule la face avant capte le rayonnement solaire. Dans une cellule bifaciale, les faces avant et arrière captent chacune une partie du rayonnement solaire. La face avant capte le rayonnement incident (i.e. direct) tandis que la face arrière capte le rayonnement diffus ou réfléchi. La face avant d'une cellule bifaciale est celle permettant d'obtenir le maximum de courant électrique lorsqu'elle est tournée vers le rayonnement incident. L'émetteur de la cellule photovoltaïque à, c'est-dire la couche de silicium amorphe dopé du type de conductivité opposé à celui du substrat 11, peut être situé en face avant ou en face arrière de la cellule.

De manière générale, le procédé de fabrication d'une cellule photovoltaïque à hétérojonction comprend (en référence à la figure 1) :

- le dépôt d'une première couche de passivation 14 en silicium amorphe hydrogéné (de préférence intrinsèque) sur une première face 11a d'un substrat 11 en silicium cristallin dopé ;
- le dépôt d'une première couche de silicium amorphe (de préférence hydrogéné) 12 dopée d'un premier type de conductivité sur la première couche de passivation 14 ;
- le dépôt d'une première couche d'oxyde transparent conducteur 15 sur la première couche de silicium amorphe 12 ; et
- la formation d'au moins une électrode de collecte 16 sur la première couche d'oxyde transparent conducteur 15 ;
- le dépôt d'une deuxième couche de passivation 14 sur une deuxième face opposée 11b du substrat 11 ;
- le dépôt d'une deuxième couche de silicium amorphe (de préférence hydrogéné) 13 sur la deuxième couche de passivation 14, la deuxième couche de silicium amorphe 13 étant dopée d'un deuxième type de conductivité opposé.

EP 4 186 110 B1

La fabrication d'une cellule photovoltaïque bifaciale, telle que la cellule photovoltaïque 10 illustrée par la figure 1, comprend en outre le dépôt d'une deuxième couche d'oxyde transparent conducteur 15 sur la deuxième couche de silicium amorphe 13 et la formation d'au moins une électrode de collecte 16 sur la deuxième couche d'oxyde transparent conducteur 15. L'une des deux première et deuxième couches de silicium amorphe 12-13 est dopée p et l'autre de ces couches 12-13 est dopée n.

Pour ne pas complexifier le procédé de fabrication de la cellule photovoltaïque en créant une étape supplémentaire, le procédé de traitement est avantageusement intégré à une étape déjà existante. Par exemple, l'empilement comprenant le substrat 11 et la première couche de passivation 14 peut être irradié lors du dépôt de la première couche de silicium amorphe dopé 12 ou du dépôt de la deuxième couche de silicium amorphe dopé 13. De préférence, l'empilement est irradié lors du dépôt de la couche de silicium amorphe dopé p (l'amélioration de la passivation étant plus sensible que lors du dépôt de la couche de silicium amorphe dopé n).

L'empilement peut être également irradié lors du dépôt de la première couche d'oxyde transparent conducteur 15 sur la première couche de silicium amorphe 12 ou, dans le cas d'une cellule bifaciale uniquement, lors du dépôt de la deuxième couche d'oxyde transparent conducteur 15 sur la deuxième couche de silicium amorphe 13. L'interface entre chaque couche d'oxyde transparent conducteur et la couche de silicium amorphe dopé sous-jacente peut être ainsi améliorée.

L'empilement peut être également illuminé lors de la formation des électrodes de collecte 16 sur la première couche d'oxyde transparent conducteur 15 ou, dans le cas d'une cellule bifaciale uniquement, sur la deuxième couche d'oxyde transparent conducteur 15. La formation des électrodes de collecte 16 comprend généralement deux opérations :

- une première opération consistant à déposer par sérigraphie une pâte métallique sur la (première ou deuxième) couche d'oxyde transparent conducteur 15 ; et
- une deuxième opération consistant à durcir la pâte métallique, par exemple au moyen d'un traitement thermique, afin de diminuer la résistivité des électrodes de collecte (métalliques).

Cette deuxième opération de durcissement de la pâte métallique et l'étape d'illumination de l'empilement sont avantageusement accomplies simultanément. La chaleur produite par l'illumination contribue ainsi au durcissement de la pâte métallique.

Comme indiqué précédemment, le procédé de traitement peut être également appliqué à une cellule photovoltaïque à hétérojonction dans son état final (après la formation des électrodes de collecte 16).

Une cellule photovoltaïque bifaciale peut être irradiée indifféremment par la face avant ou par la face arrière. En effet, ni la couche d'oxyde transparent conducteur 15, ni les électrodes de collecte 16 (présentes en face avant et en face arrière de la cellule) ne font obstacle au rayonnement électromagnétique 20.

L'irradiation d'une cellule photovoltaïque monofaciale s'effectue par la face avant, la cellule comprenant en face arrière une métallisation opaque qui occupe toute la surface ou un réseau d'électrodes suffisamment dense pour bloquer la majeure partie du rayonnement électromagnétique.

Le procédé de traitement peut être appliqué également à une cellule photovoltaïque à hétérojonction au sein d'un module photovoltaïque. Dans un module photovoltaïque, les échanges de chaleur sont limités par le matériau d'encapsulation des cellules photovoltaïques. En limitant les surchauffes, le procédé de traitement selon l'invention apporte une solution d'autant plus pertinente.

Le procédé de traitement selon l'invention n'est pas limité aux modes de mise en oeuvre décrits ci-dessus et de nombreuses variantes et modifications du procédé de traitement apparaitront à l'homme du métier.

Par exemple, le faisceau d'ondes électromagnétiques émis par la source de rayonnement peut ne pas être orienté perpendiculairement à la surface de l'empilement. En l'inclinant par rapport à la normale de la face de l'empilement, d'un angle inférieur à 90° (en valeur absolue), il est possible de faire varier la surface irradiée par le faisceau ainsi que la densité de puissance reçue par unité de surface. L'inclinaison peut être constante au cours du procédé de traitement ou être modulée au moyen d'une rotation de la source de rayonnement, par exemple de façon à réduire la densité surfacique d'énergie reçue par l'empilement en fin de balayage (c.-à-d. à l'approche de bord de fuite) et à limiter encore davantage la surchauffe ou de réduire encore la distance d à laquelle l'exposition au rayonnement électromagnétique est interrompue.

Enfin, le procédé de traitement est applicable à un empilement 10' comprenant un substrat 11 en silicium cristallin dopé de type p (plutôt qu'en silicium cristallin dopé de type n).

## Revendications

1. Procédé de traitement d'un empilement (10') obtenu lors de la fabrication d'une cellule photovoltaïque à hétérojonction, afin d'améliorer le rendement de la cellule photovoltaïque, l'empilement comprenant un substrat (11) en silicium cristallin et une couche de passivation (14) en silicium amorphe hydrogéné disposée sur le substrat (11), ledit procédé comprenant une étape d'exposition d'une face de l'empilement (10') à un rayonnement électromagnétique (20) émis par une source de rayonnement (40), ledit procédé étant **caractérisé en ce que** le rayonnement électromagnétique (20) est appliqué à la face de l'empilement (10') selon une ligne (50), l'empilement (10') et la source de rayonnement (40) étant animés d'un mouvement relatif de translation dans une direction de déplacement (D) telle que la ligne (50) balaye une partie au moins de la face de l'empilement (10').

2. Procédé selon la revendication 1, dans lequel la face de l'empilement (10') comprend :

   - un premier bord (100a) appelé bord d'attaque ;
   - un deuxième bord (100b) appelé bord de fuite et opposé au premier bord (100a) ; et
   - des troisième et quatrième bords (100c, 100d) reliant les premier et deuxième bords (100a, 100b).

3. Procédé selon la revendication 2, dans lequel la ligne (50) comprend un segment de droite (51) orienté perpendiculairement à une médiane (M) de la face de l'empilement (10'), la médiane passant par le bord d'attaque (100a) et le bord de fuite (100b).

4. Procédé selon la revendication 2, dans lequel la ligne (50) comprend un segment de droite (51') incliné par rapport à une médiane (M) de la face de l'empilement (10') d'un angle ($\alpha$) strictement inférieur à 90° en valeur absolue, la médiane (M) passant par le bord d'attaque (100a) et le bord de fuite (100b).

5. Procédé selon la revendication 4, dans lequel la ligne (50) est une ligne brisée comprenant un premier segment de droite (52a) incliné par rapport à une médiane (M) de la face de l'empilement (10') d'un premier angle positif ($\alpha_1$) et un deuxième segment de droite (52b) incliné par rapport à la médiane (M) d'un deuxième angle négatif ($\alpha_2$), la médiane (M) passant par le bord d'attaque (100a) et le bord de fuite (100b), le premier angle ($\alpha_1$) et le deuxième angle ($\alpha_2$) étant inférieurs à 90° en valeur absolue.

6. Procédé selon l'une quelconque des revendications 1 à 5, dans lequel la ligne (50) balaye plus de 60 % de la face de l'empilement (10'), et de préférence moins de 100 % de la face de l'empilement (10').

7. Procédé selon l'une des revendications 2 et 3, dans lequel la ligne (50) balaye une partie seulement de la face de l'empilement (10'), en commençant par le premier bord (100a), l'étape d'exposition de la face de l'empilement (10') au rayonnement électromagnétique (20) étant interrompue avant que la ligne n'atteigne le deuxième bord (100b).

8. Procédé selon la revendication 7, dans lequel l'étape d'exposition de la face de l'empilement (10') au rayonnement électromagnétique (20) est interrompue lorsque la ligne (50) se situe à une distance du deuxième bord (100b) déterminée en fonction d'une température de dégradation du silicium amorphe.

9. Procédé selon l'une des revendications 7 et 8, dans lequel l'étape d'exposition de la face de l'empilement (10') au rayonnement électromagnétique (20) est interrompue à un instant ($t_{stop}$) où une portion de l'empilement (50) atteint une température de dégradation du silicium amorphe.

10. Procédé selon l'une quelconque des revendications 1 à 9, dans lequel la densité surfacique d'énergie (Q) reçue en tout point de la face de l'empilement (10') est comprise entre 1 kJ/m$^2$ et 1000 kJ/m$^2$, avantageusement entre 10 kJ/m$^2$ et 100 kJ/m$^2$.

11. Procédé selon l'une quelconque des revendications 1 à 10, dans lequel le rayonnement électromagnétique (20) présente une irradiance (E) supérieure ou égale à 1 kW/m$^2$, de préférence comprise entre 100 kW/m$^2$ et 5000 kW/m$^2$.

12. Procédé selon l'une quelconque des revendications 1 à 11, dans lequel l'empilement (10) et la source de rayonnement (40) sont en mouvement relatif de translation à une vitesse de déplacement (V) comprise entre 1 cm/s et 100 cm/s, de préférence supérieure ou égale à 2 cm/s.

13. Procédé selon l'une quelconque des revendications 1 à 12, dans lequel la ligne (50) présente une largeur (L) comprise entre 0,1 mm et 100 mm, de préférence comprise entre 1 mm et 10 mm.

14. Procédé selon l'une quelconque des revendications 1 à 13, dans lequel la source de rayonnement (40) émet un faisceau d'ondes électromagnétiques incliné par rapport à la normale de la face de l'empilement.

15. Procédé de fabrication d'une cellule photovoltaïque à hétérojonction (10), comprenant les étapes suivantes :

   - former un empilement (10') en déposant une couche de passivation (14) en silicium amorphe hydrogéné sur un substrat (11) en silicium cristallin ; et
   - soumettre l'empilement (10') à un procédé de traitement selon la revendication 1.

**Patentansprüche**

1. Verfahren zur Behandlung eines Stapels (10'), der bei der Herstellung einer Photovoltaikzelle mit Heterojunction erhalten wird, um den Wirkungsgrad der Photovoltaikzelle zu verbessern, wobei der Stapel ein Substrat (11) aus kristallinem Silizium und eine Passivierungsschicht (14) aus hydriertem amorphen Silizium umfasst, die auf dem Substrat (11) angeordnet ist, wobei das Verfahren einen Schritt umfasst, bei dem eine Stapelseite (10') einer elektromagnetischen Strahlung (20) ausgesetzt wird, die von einer Strahlungsquelle (40) emittiert wird, wobei das Verfahren **dadurch gekennzeichnet ist, dass** die elektromagnetische Strahlung (20) auf der Stapelseite (10') entlang einer Linie (50) angewendet wird, wobei der Stapel (10') und die Strahlungsquelle (40) in eine relative Translationsbewegung in einer derartigen Verschiebungsrichtung (D) versetzt werden, dass die Linie (50) mindestens einen Teil der Stapelseite (10') überstreift.

2. Verfahren nach Anspruch 1, bei dem die Stapelseite (10') umfasst:

   - eine erste Kante (100a), die als Vorderkante bezeichnet wird;
   - eine zweite Kante (100b), die als Hinterkante bezeichnet wird und der ersten Kante (100a) gegenüberliegt; und
   - dritte und vierte Kanten (100c, 100d), die die erste und zweite Kante (100a, 100b) verbinden.

3. Verfahren nach Anspruch 2, bei dem die Linie (50) ein Geradensegment (51) umfasst, das senkrecht zu einer Mittellinie (M) der Stapelseite (10') ausgerichtet ist, wobei die Mittellinie durch die Vorderkante (100a) und die Hinterkante (100b) verläuft.

4. Verfahren nach Anspruch 2, bei dem die Linie (50) ein Geradensegment (51') umfasst, das in Bezug auf eine Mittellinie (M) der Stapelseite (10') um einen Winkel ($\alpha$) geneigt ist, der absolut gesehen strikt kleiner als 90° ist, wobei die Mittellinie (M) durch die Vorderkante (100a) und die Hinterkante (100b) verläuft.

5. Verfahren nach Anspruch 4, bei dem die Linie (50) eine gebrochene Linie ist, die ein erstes Geradensegment (52a), das in Bezug auf eine Mittellinie (M) der Stapelseite (10') um einen ersten positiven Winkel ($\alpha_1$) geneigt ist, und ein zweites Geradensegment (52b) umfasst, das in Bezug auf die Mittellinie (M) um einen zweiten negativen Winkel ($\alpha_2$) geneigt ist, wobei die Mittellinie (M) durch die Vorderkante (100a) und die Hinterkante (100b) verläuft, wobei der erste Winkel ($\alpha_1$) und der zweite Winkel ($\alpha_2$) im Absolutwert kleiner als 90° sind.

6. Verfahren nach einem der Ansprüche 1 bis 5, bei dem die Linie (50) mehr als 60 % der Stapelseite (10') und vorzugsweise weniger als 100 % der Stapelseite (10') überstreift.

7. Verfahren nach einem der Ansprüche 2 und 3, bei dem die Linie (50) nur einen Teil der Stapelseite (10') überstreift, beginnend mit der ersten Kante (100a), wobei der Schritt des Belichtens der Stapelseite (10') mit elektromagnetischer Strahlung (20) unterbrochen wird, bevor die Linie die zweite Kante (100b) erreicht.

8. Verfahren nach Anspruch 7, bei dem der Schritt des Belichtens der Stapelseite (10') mit elektromagnetischer Strahlung (20) unterbrochen wird, wenn die Linie (50) sich in einem Abstand von der zweiten Kante (100b) befindet, der in Abhängigkeit von einer Abbautemperatur des amorphen Siliziums bestimmt wird.

9. Verfahren nach einem der Ansprüche 7 und 8, bei dem der Schritt des Belichtens der Stapelseite (10') mit elektromagnetischer Strahlung (20) zu einem Zeitpunkt ($t_{stop}$) unterbrochen wird, zu dem ein Teil des Stapels (50) eine Abbautemperatur des amorphem Silizium erreicht.

10. Verfahren nach einem der Ansprüche 1 bis 9, bei dem die Energieflächendichte (Q), die an jedem Punkt der Stapelseite (10') erhalten wird, zwischen 1 kJ/m$^2$ und 1000 kJ/m$^2$, vorzugsweise zwischen 10 kJ/m$^2$ und 100 kJ/m$^2$ liegt.

11. Verfahren nach einem der Ansprüche 1 bis 10, bei dem die elektromagnetische Strahlung (20) eine Bestrahlungsstärke (E) aufweist, die größer oder gleich 1 kW/m$^2$ ist und vorzugsweise zwischen 100 kW/m$^2$ und 5000 kW/m$^2$ liegt.

**12.** Verfahren nach einem der Ansprüche 1 bis 11, bei dem sich der Stapel (10) und die Strahlungsquelle (40) in einer relativen Translationsbewegung mit einer Bewegungsgeschwindigkeit (V) zwischen 1 cm/s und 100 cm/s, vorzugsweise größer oder gleich 2 cm/s befinden.

**13.** Verfahren nach einem der Ansprüche 1 bis 12, bei dem die Linie (50) eine Breite (L) zwischen 0,1 mm und 100 mm aufweist, vorzugsweise zwischen 1 mm und 10 mm.

**14.** Verfahren nach einem der Ansprüche 1 bis 13, bei dem die Strahlungsquelle (40) einen Strahl elektromagnetischer Wellen aussendet, der bezüglich der Normalen der Stapelseite geneigt verläuft.

**15.** Verfahren zur Herstellung einer Photovoltaikzelle mit Heterojunction (10), das die folgenden Schritte umfasst:

    - Bilden eines Stapels (10') durch Auftragen einer Passivierungsschicht (14) aus hydriertem amorphen Silizium auf ein Substrat (11) aus kristallinem Silizium; und
    - Unterziehen des Stapels (10') einem Behandlungsverfahren nach Anspruch 1.

**Claims**

**1.** A method for treating a stack (10') obtained upon manufacturing a heterojunction photovoltaic cell, in order to improve the efficiency of the photovoltaic cell, the stack comprising a crystalline silicon substrate (11) and a hydrogenated amorphous silicon passivation layer (14) disposed on the substrate (11), said method comprising a step of exposing a face of the stack (10') to electromagnetic radiation (20) emitted by a radiation source (40), said method being **characterised in that** the electromagnetic radiation (20) is applied to the face of the stack (10') along a line (50), the stack (10') and the radiation source (40) being relatively translationally moving in a direction of displacement (D) such that the line (50) scans at least part of the face of the stack (10').

**2.** The method according to claim 1, wherein the face of the stack (10') comprises:

    - a first edge (100a) referred to as the leading edge;
    - a second edge (100b) referred to as the trailing edge and opposite to the first edge (100a); and
    - third and fourth edges (100c, 100d) connecting the first and second edges (100a, 100b).

**3.** The method according to claim 2, wherein the line (50) comprises a line segment (51) oriented perpendicularly to a median (M) of the face of the stack (10'), the median passing through the leading edge (100a) and the trailing edge (100b).

**4.** The method according to claim 2, wherein the line (50) comprises a line segment (51') tilted with respect to a median (M) of the face of the stack (10') by an angle ($\alpha$) strictly less than 90° in absolute value, the median (M) passing through the leading edge (100a) and the trailing edge (100b).

**5.** The method according to claim 4, wherein the line (50) is a broken line comprising a first line segment (52a) tilted with respect to a median (M) of the face of the stack (10') by a first positive angle ($\alpha_1$) and a second line segment (52b) tilted with respect to the median (M) by a second negative angle ($\alpha_2$), the median (M) passing through the leading edge (100a) and the trailing edge (100b), the first angle ($\alpha_1$) and the second angle ($\alpha_2$) being less than 90° in absolute value.

**6.** The method according to any of claims 1 to 5, wherein the line (50) scans more than 60% of the face of the stack (10'), and preferably less than 100% of the face of the stack (10').

**7.** The method according to one of claims 2 and 3, wherein the line (50) scans only part of the face of the stack (10'), starting with the first edge (100a), the step of exposing the face of the stack (10') to the electromagnetic radiation (20) being interrupted before the line reaches the second edge (100b).

**8.** The method according to claim 7, wherein the step of exposing the face of the stack (10') to the electromagnetic radiation (20) is interrupted when the line (50) is located at a distance from the second edge (100b) determined as a function of a degradation temperature of amorphous silicon.

9. The method according to one of claims 7 and 8, wherein the step of exposing the face of the stack (10') to the electromagnetic radiation (20) is interrupted at a time instant ($t_{stop}$) when a portion of the stack (50) reaches a degradation temperature of amorphous silicon.

10. The method according to any of claims 1 to 9, wherein the energy surface density (Q) received at any point of the face of the stack (10') is between 1 kJ/m$^2$ and 1000 kJ/m$^2$, advantageously between 10 kJ/m$^2$ and 100 kJ/m$^2$.

11. The method according to any of claims 1 to 10, wherein the electromagnetic radiation (20) has an irradiance (E) greater than or equal to 1 kW/m$^2$, preferably of between 100 kW/m$^2$ and 5000 kW/m$^2$.

12. The method according to any of claims 1 to 11, wherein the stack (10) and the radiation source (40) are relatively translationally moving at a displacement speed (V) of between 1 cm/s and 100 cm/s, preferably greater than or equal to 2 cm/s.

13. The method according to any of claims 1 to 12, wherein the line (50) has a width (L) of between 0.1 mm and 100 mm, preferably of between 1 mm and 10 mm.

14. The method according to any of claims 1 to 13, wherein the radiation source (40) emits an electromagnetic wave beam tilted with respect to the normal of the face of the stack.

15. A method for manufacturing a heterojunction photovoltaic cell (10), comprising the following steps of:

    - forming a stack (10') by depositing a hydrogenated amorphous silicon passivation layer (14) onto a crystalline silicon substrate (11); and
    - subjecting the stack (10') to a treatment method according to claim 1.

16   16   11a
15
12
14

11

14
13
15

11b

10   16   16

# FIG. 1

40

20

11a
14  10'
11b   11

30

# FIG. 2

FIG. 3

FIG. 4

ΔT (°C)

FIG. 5A

δ (mm)

FIG. 5B

FIG. 6

FIG. 7

FIG. 8

FIG. 9

FIG. 10

FIG. 11

FIG. 12

FIG. 13

FIG. 14

FIG. 15

FIG. 16

## RÉFÉRENCES CITÉES DANS LA DESCRIPTION

**Documents brevets cités dans la description**

- WO 2013001440 A
- CN 107546296 A